# EUROPEAN PATENT APPLICATION

(11) **EP 1 641 123 A1**
(43) Date of publication of application: **29.03.2006**
(21) Application number: 05255817.8
(22) Date of filing: 20.09.2005
(51) Int. Cl.: H03L 1/02

(54) **Temperature-stabilized crystal oscillator and stabilisation method thereof**

(30) Priority: 21.09.2004 JP 2004274118
(71) Applicant: Nihon Dempa Kogyo Co., Ltd., Tokyo 151-0066 (JP)
(72) Inventor: Oita, Takeo, Sayama-shi Saitama 350-1321 (JP); Sakamoto, Katsuaki, Sayama-shi Saitama 350-1321 (JP); Fukuda, Minoru, Sayama-shi Saitama 350-1321 (JP); Sakaba, Yasuo, Sayama-shi Saitama 350-1321 (JP)
(74) Representative: Lucas, Brian Ronald

(57) **Abstract**

A crystal oscillator comprising a heater (11b,22) having duplicate lines and a control unit for controlling the heater (11b,22), by driving two currents with opposite phases in the pair of two heater lines.

## Description

### Background of the Invention

### Field of the Invention

The present invention relates to a crystal oscillator for guaranteeing high frequency precision against temperature fluctuations.

### Description of the Related Art

As a crystal oscillator with the high stability of an oscillating frequency against the fluctuations of ambient temperature, a temperature compensated crystal oscillator (TCXO) and an oven controlled crystal oscillator (OCXO) are known.

The TCXO comprises a temperature-compensated circuit for correcting an oscillating frequency according to the fluctuations of ambient temperature. In the OCXO, a crystal oscillator element or an oscillation circuit is disposed in a constant-temperature oven whose internal temperature is kept constant to reduce its influence on ambient temperature.

Although the TCXO is suitable for low power, it is technically difficult to guarantee high frequency precision of 10⁻⁷ or less against temperature fluctuations. However, although the OCXO has an advantage over the TCXO in achieving high frequency precision, it stands at a disadvantage in low power.

In order to solve the problem, for example, Patent reference 1 (the specification (Fig. 1) of US Patent No. 5917272) discloses an OCXO which comprises a heater on a heat conductive substrate in order to efficiently heat by heat conduction and radiation and to save power. Since in this configuration, a crystal element cannot be disposed in such a way as to enclose the heater, the influence of ambient temperature increases.

One factor of the high consumption power of the OCXO is a complex temperature control circuit for keeping the temperature of the constant-temperature oven.

For temperature control, there are an analog method in which it is difficult to miniaturize/integrate circuits and a pulse width modulation (PWM) method in which circuits can be easily miniaturized and integrated.

Since a heater drive circuit can be fairly miniaturized, control by PWM is used to control the temperature of a laser diode. However, a pulse residue is superimposed on a temperature control driving signal. If such a driving signal is applied to a heater, an electro-magnetic field generated from the heater is superimposed on the oscillating signal of a crystal oscillator disposed adjacently to it. Therefore, it is unsuitable for temperature control.

When temperature control is attempted to realize by control by PWM, there is no conventional method for effectively eliminating noise due to control by PWM. Therefore, a signal obtained by increasing/decreasing DC voltage without noise must be used. In this case, since for a heater drive transistor, one with a large collector loss must be used, the setting of a circuit constant becomes complex and also a large device must be used. Therefore, a control circuit becomes complex and large.

### Summary of the Invention

It is an object of the present invention to provide a small low-powered crystal oscillator and a temperature-keeping method thereof.

In order to solve the above-described problem, the crystal oscillator according to the present invention comprises a heater and a control unit.

The heater has multiplied heater lines.

The control unit controls the heater.

In this configuration, an object whose temperature is kept constant is heated by the multiplied heater.

Since each heater line of the heater is duplicated, the control unit can also flow two pieces of driving current each with an opposite phase to each pair of duplicated heater lines.

Since in this configuration, by the pair of heater lines through each of which current with an opposite phase, respective noise can be mutually killed by the heater lines, the object to be heated by the heater is not affected by the noise on the heater lines.

Furthermore, the heater can also be configured in such a way that the object whose temperature is kept constant by the heater may be enclosed with the heater lines.

Thus, the object whose temperature is kept constant can be actually kept at a preset temperature without being affected by ambient temperature.

The control unit controls the heater by pulse width modulation (PWM). Thus, the miniaturization and power saving of an oscillator can be realized.

The present invention covers not only a crystal oscillator but also the temperature-keeping method of an object whose temperature is kept constant in a crystal oscillator.

According to the present invention, since an object whose temperature is kept constant can be actually kept at a preset temperature without being affected by ambient temperature, highly precise oscillation which is stable against temperature fluctuations can be realized.

A control method in which noise is superimposed on heater lines, such as PWM can be adopted for the control of a heater. Furthermore, by adopting PWM control, the miniaturization and power saving of a temperature control circuit can be realized.

Furthermore, since an oscillator can be miniaturized, stable oscillation output can be realized in a short time after the oscillator is activated.

### Brief Description of the Drawings

Fig. 1A and 1B show the configurations of the heater of the conventional oscillator and that of the oscillator in this preferred embodiment of the present invention, respectively.
Fig. 2 shows one disposition of the heater of the crystal oscillator and an object whose temperature is kept constant in this preferred embodiment.
Fig. 3 shows another disposition of the heater of the crystal oscillator and an object whose temperature is kept constant in this preferred embodiment.
Fig. 4 shows an example of the circuit configuration of the crystal oscillator in this preferred embodiment.
Fig. 5 is the section view showing one disposition of components constituting the oscillation circuit in this preferred embodiment.
Figs. 6A, 6B and 6C show examples of the configurations of the differential-driven heater (DDH).

### Description of the Preferred Embodiment

One preferred embodiment of the oscillator according to the present invention is described below with reference to the drawings.

In the oscillator of this preferred embodiment, a plurality of heater lines of a heater for keeping components which affect the oscillating frequency of the oscillator by the fluctuations of their temperature, such as a crystal oscillator element and the like, in a constant temperature as objects whose temperature should be kept constant are disposed adjacently to each other. The crystal oscillator is disposed in an area with a weak electro-magnetic field, which is enclosed with a heater and in which AC noise superimposed on a driving signal is mutually killed by flowing two pieces of driving current each with an opposite phase to each pair of heater lines. Thus, even if a control method in which there is a possibility that noise is superimposed on a driving signal, such as control by PWD for the temperature control of the heater or the like, is used, respective noise can be mutually killed by the respective electro-magnetic fields of each pair of heater lines.

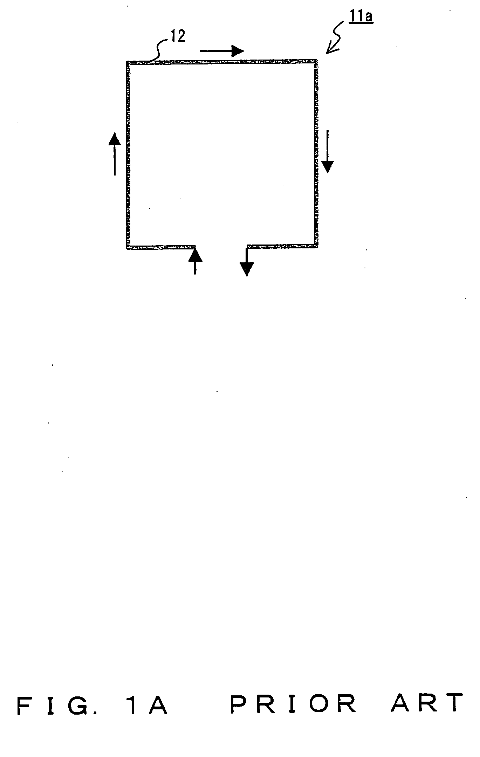

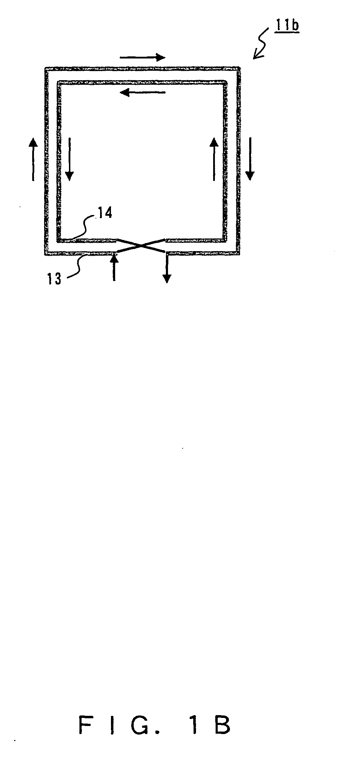

Fig. 1A and 1B show the configurations of the heater of the conventional oscillator and that of the oscillator in this preferred embodiment of the present invention, respectively.

As shown in Fig. 1A, in the conventional heater 11a of a crystal oscillator, a loop-shaped heater line 12 is provided on a substrate in such a way as to enclose an object whose temperature is kept constant, such as a crystal element or a circuit device constituting an oscillation circuit, disposed at the center of the substrate.

However, in the heater 11b of the crystal oscillator in this preferred embodiment, each heater line is duplicated as shown in Fig. 1B, and a heater line 14 is disposed inside a heater line 13. The two heater lines 13 and 14 are connected to a temperature control circuit for driving the heater crosswise, and current is applied to each of the heater lines 13 and 14 in an opposite direction. Thus, noise superimposed on the heater line 14 and one superimposed on the heater line 13 are mutually killed and an object whose temperature is kept constant is protected from noise. Therefore, even if control by pulse width modulation (PWM) is used for this heater control, noise superimposed on a signal for driving the heater does not affect the output of the crystal oscillation circuit, thereby realizing an oscillator capable of outputting a highly precise oscillating signal.

In the following description, a general heater shown in 1A and the heater of the oscillator in this preferred embodiment shown in Fig. 1B are called "single-driven heater (SDH)" and "differential-driven heater (DDH)", respectively.

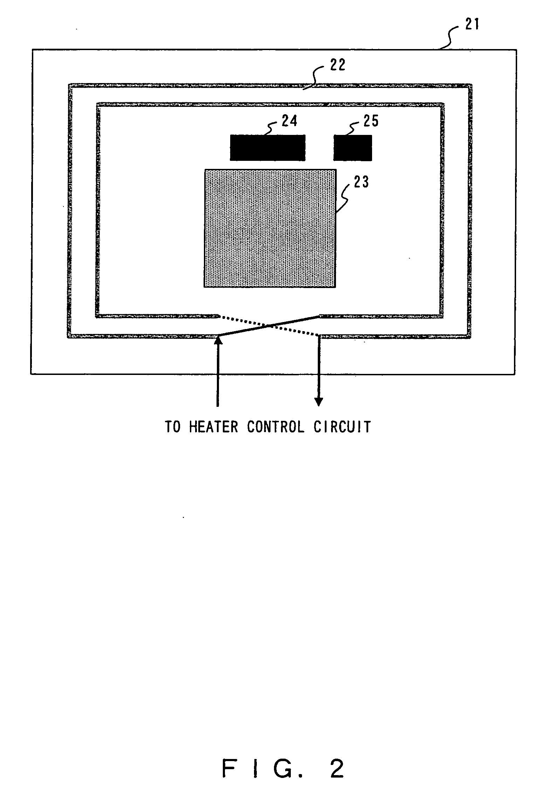

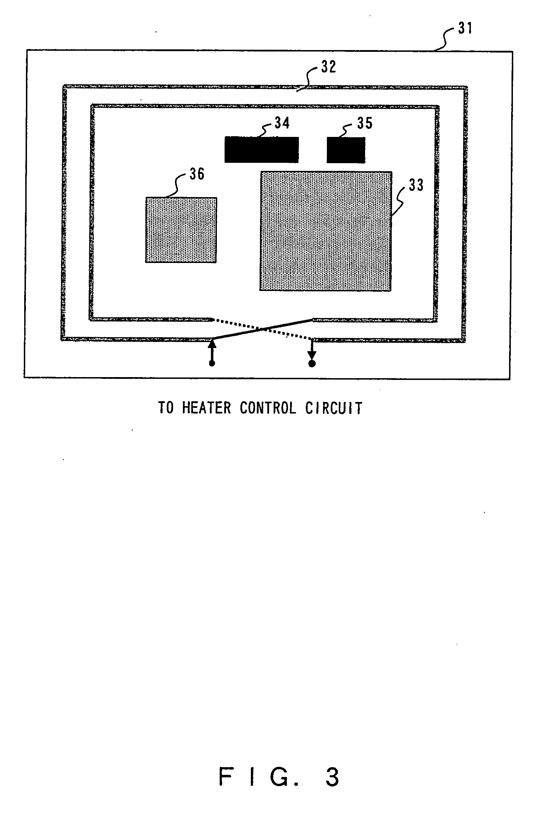

Figs. 2 and 3 shows disposition examples of a heater and an object whose temperature is kept constant.

In Fig. 2, a crystal oscillation circuit is disposed inside the heater as an object whose temperature is kept constant by the heater.

In Fig. 2, a DDH 22 obtained by forming a thick film-baked heater resistor is disposed on a ceramic substrate 21. An IC chip 23 obtained by integrating a crystal oscillator element and circuit components constituting a VCXO and packaging them into a ceramic or the like, a temperature sensor 24 for sensing the temperature inside the DDH 22, such as a thermistor or the like and a discrete component 25, such as a large-capacity capacitor which cannot be accommodated in the IC chip 23 and the like are disposed at the center of the enclosure of the DDH 22 in such a way as to be enclosed with the DDH 22 as objects whose temperature should be kept constant.

In Fig. 3, a temperature control circuit 36 for controlling DDH32 as well as the IC chip 33, a temperature sensor 34and discrete components 35 shown in Fig. 2 are disposed inside the DDH 32 as objects whose temperature should be kept constant as an example.

This temperature control circuit 36 keeps the respective temperature of the IC chip 33, temperature sensor 34, discrete components 35 and temperature control circuit 36 which are disposed inside the DDH 32 formed on the ceramic substrate 31 by PWM-controlling the DDH 32, based on the resistance value of the temperature sensor 34 which changes with temperature fluctuation.

In the oscillator configured as shown in Fig. 2 or 3, since an object whose temperature is kept constant is enveloped and heated in the DDH 22 (or DDH 32), the temperature of the object is actually kept at a preset temperature without being affected by ambient temperature.

By adopting the control by PWM of the temperature control circuit and controlling temperature by changing the pulse width of current for driving the DDH 22 (or DDH 32), even if as a result, AC noise superimposed on current flowing through the DDH 22 (or DDH 32) , an object whose temperature is kept constant, such as the chip of an oscillation circuit disposed inside the DDH 22 (or DDH 32) can realize essential oscillation with high frequency precision without being affected by noise superimposed on the heater lines since respective noise can be mutually killed by the respective electro-magnetic fields of the two duplicated heater lines of the DDH 22 (DDH 32).

Furthermore, since temperature control by PWM is possible, the miniaturization and low power of the entire device can be realized, and the device can also be adopted for portable equipment or the like. By the miniaturization of equipment, time required to make the temperature of the object whose temperature is kept constant a specified value can be shortened, and time required until stable oscillation output is secured after activation can be shortened.

Although in Figs. 2 and 3, only one of the temperature sensors 24 and 34 is disposed in the neighborhood of the object whose temperature is kept constant, a plurality of temperature sensors can also be disposed inside the DDHs 22 and 32. In this case, the plurality of temperature sensors is connected in series, and temperature is controlled based on the total resistance value. Alternatively, the plurality of temperature sensors is connected in parallel, and temperature is controlled by determining the value of each temperature sensor by majority. In this case, the temperature sensors are disposed in appropriate positions, such as in the four corners, at the center of the DDHs 22 and 32 and the like, taking into consideration the temperature distribution of the substrate and the like.

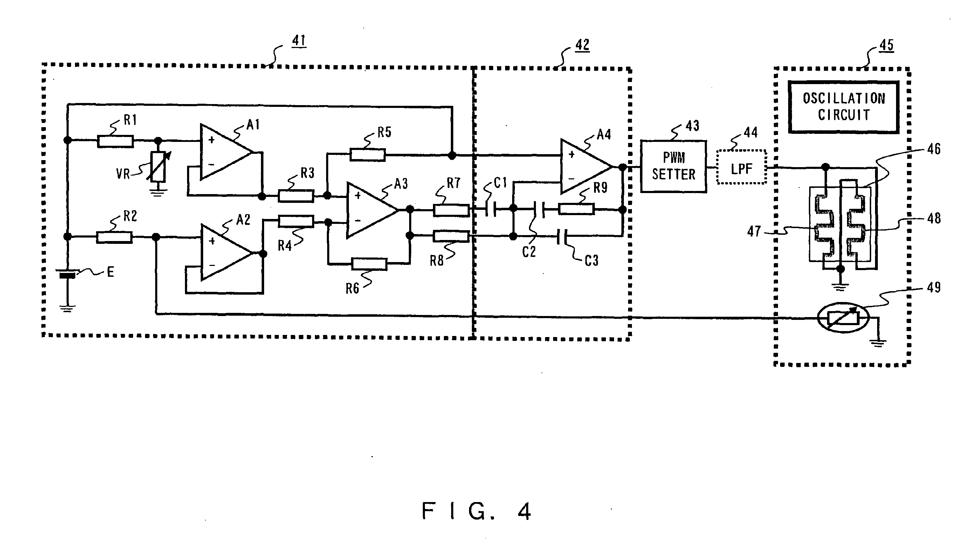

Fig. 4 shows an example of the circuit configuration of the crystal oscillator in this preferred embodiment. Fig. 4 shows the case where a DDH is controlled PWM. In Fig. 4, mainly a temperature control circuit is described, and descriptions other than a part concerning the control of the DDH are simplified.

In the crystal oscillator of this preferred embodiment, the oscillation circuit 45, DDH 46 and temperature sensor 49, such as a thermistor or the like, which are shown in Fig. 2 are thermally connected by a substrate made of ceramic or the like, and the heater lines 47 and 48 of the DDH 46 are disposed so as to enclose the oscillation circuit 45 and the temperature sensor 49 disposed in the neighborhood of the oscillation circuit 45 doubly.

The DDH 46 and temperature sensor 49 is electrically connected to the temperature control circuit composed of an error signal generator 41, an integrator 42 and a PWM setter 43. The temperature control circuit PWM-controls the DDH 46, based on the change by heat of the resistance value of the temperature sensor 49.

The error signal generator 41 compares a specified voltage generated by resistors R1 and R3, an operational amplifier A1 and a variable resistor VR with the output voltage of an amplifier composed of the temperature sensor 49, resistors R2 and R4 and an operational amplifier A2, using a differential amplifier composed of a chopper amplifier A3 and resistors R5 and R6, and inputs the differential value to the integrator 42. A voltage source E provides the error signal generator 41 and integrator 42 with their reference voltages.

In the integrator 42, after unwanted noise is cut from the output of the chopper amplifier A3, using a low-pass filter composed by resistors R7 and R8 and a capacitor C1, an error signal whose timing is synchronous with a temperature time constant is generated by an integrator composed of an amplifier A4, capacitors C2 and C3 and a resistor R9 and inputted to the PWM setter 43.

This error signal notifies the PWM setter 43 that temperature inside the DDH 46 deviates from a set temperature. If the temperature inside the DDH 46 exceeds a temperature set by the variable resistor VR and the resistance value of the temperature sensor 49 increases, an error signal with plus voltage is inputted from the integrator42 to the PWM setter 43. If conversely, the temperature drops below the set temperature and the resistance value of the temperature sensor 49 decreases, an error signal with minus voltage is inputted from the integrator 42 to the PWM setter 43. The PWM setter 43 controls temperature by expanding/contracting the pulse width of current for driving the DDH 46, according to the voltage value of this error signal. In this case, if necessary, a low-pass filter 44 can also be provided between the PWM setter 43 and DDH 46 and an error signal can also be inputted to the DDH 46 after noise which is superimposed on the error signal outputted from the PWM setter 43 is eliminated by this low-pass filter 44.

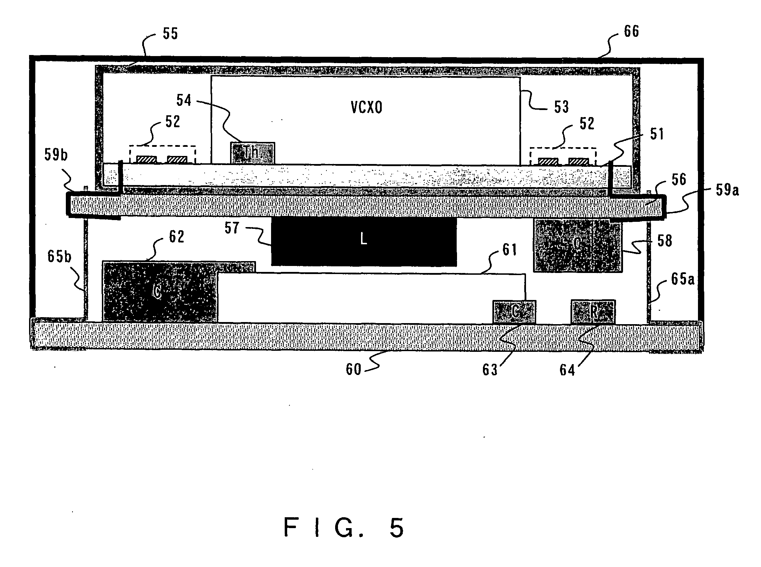

Fig. 5 is the section view showing one disposition of components constituting the oscillation circuit in this preferred embodiment. In the oscillation circuit of this preferred embodiment, each component is three-dimensionally disposed in a container in order to realize miniaturization.

In Fig. 5, in the oscillation circuit of this preferred embodiment, a chip 53 constituting an oscillator and a temperature sensor 54 for detecting temperature, which are obj ects whose temperature is kept constant, are disposed inside a DDH 52 formed on a ceramic substrate 51, using a thick-film resistor and are vacuum-sealed by an insulation material 55. A glass epoxy substrate 56 on which a capacitor 57 and an inductance 58, which constitute a low-pass filter, are mounted is connected to the opposite side of the ceramic substrate 51 by couplers 59a and 59b.

An Integrated circuit 61 obtained by integrating temperature control circuits composed of the error signal generator 41, integrator 42 and PWM setter 43 which are shown in Fig. 4, decoupling capacitors 62 and 63 for power supply and heater current monitor and a resistor 64 for controlled temperature setting and reference voltage adjustment are disposed on the glass epoxy substrate 60. This substrate 60 is opposed to and coupled with the glass epoxy substrate 56 by couplers 65a and 65b, and are sealed by a metal cover 66.

By adopting such a configuration, the area of the ceramic substrate 51, which is heated by the DDH 52, can be reduced and also its consumption power can be reduced. Thus, inside temperature vacuum-sealed by the DDH 52 can be adjusted well responsively.

In this configuration, firstly the DDH 52 is affected by the fluctuations of ambient temperature, and then, the respective temperatures of the temperature sensor 54 and chip 53 are affected. An influence on the temperature sensor 54 by the fluctuations of ambient temperature is extracted as an error signal, and by the temperature control circuit feeds back it to the DDH 52 as heater current, temperature can be controlled. Thus, since heat is difficult to go to the outside in a part sealed inside the DDH 52 in which the chip 53 and the like are disposed, temperature drop inclination in the area can be suppressed to a low level.

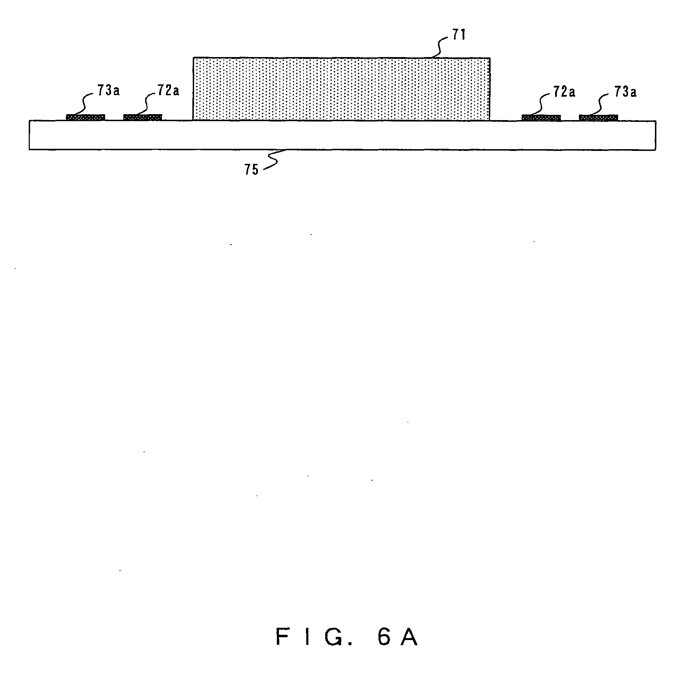

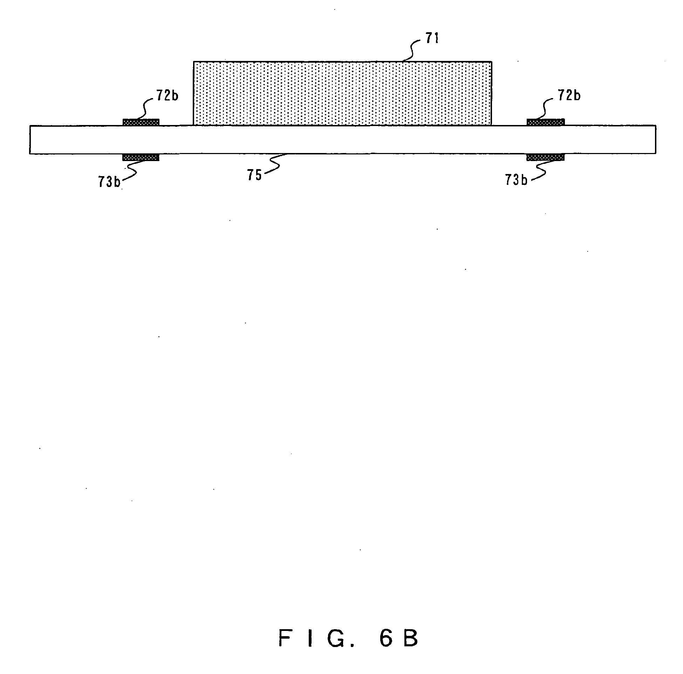

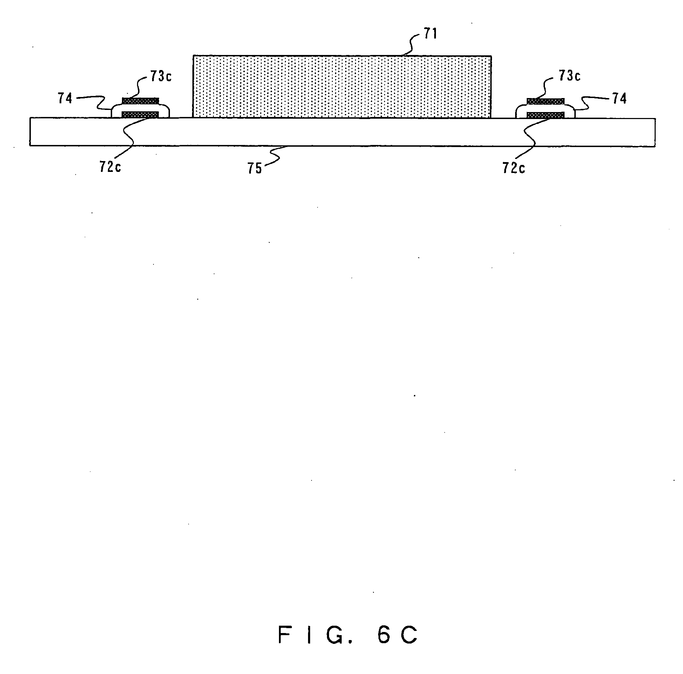

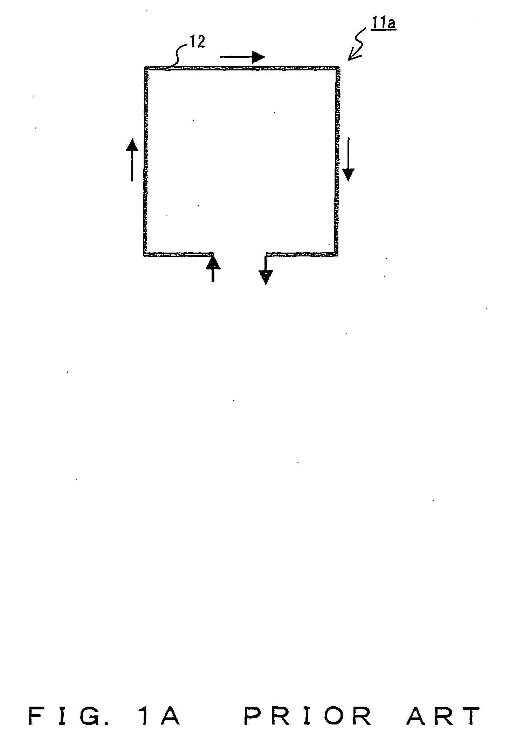

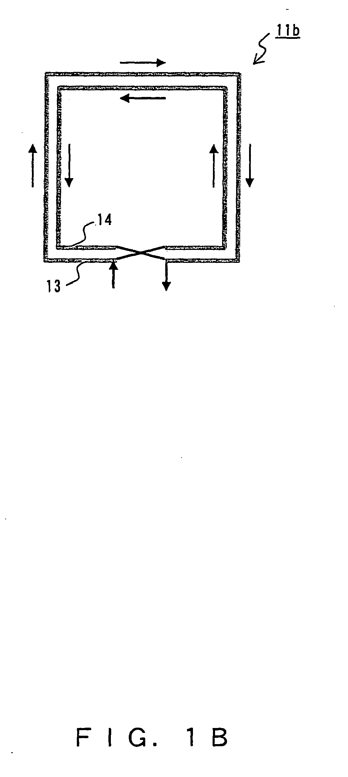

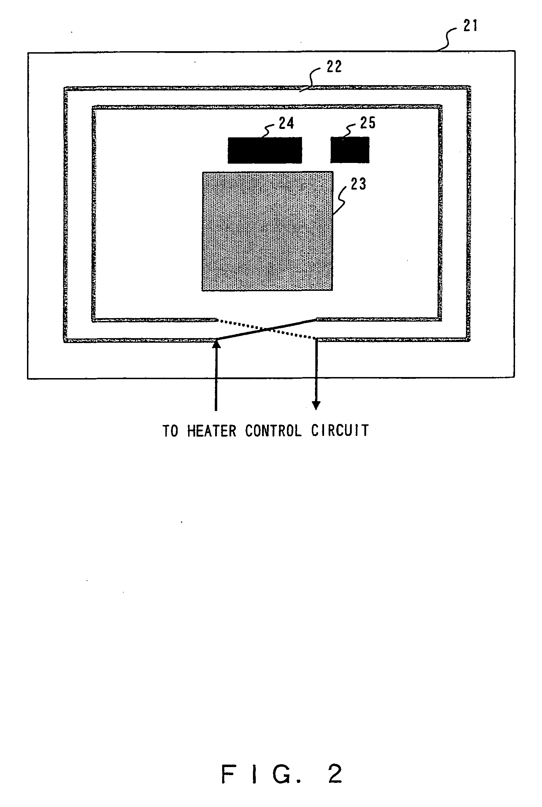

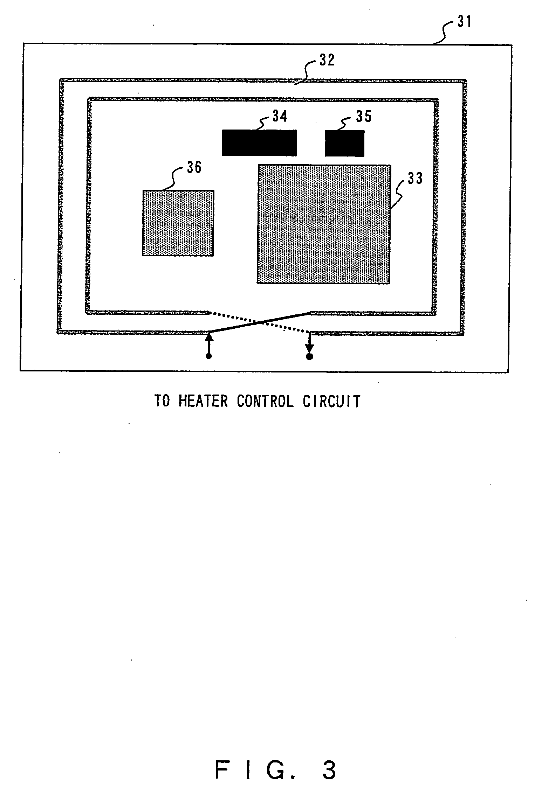

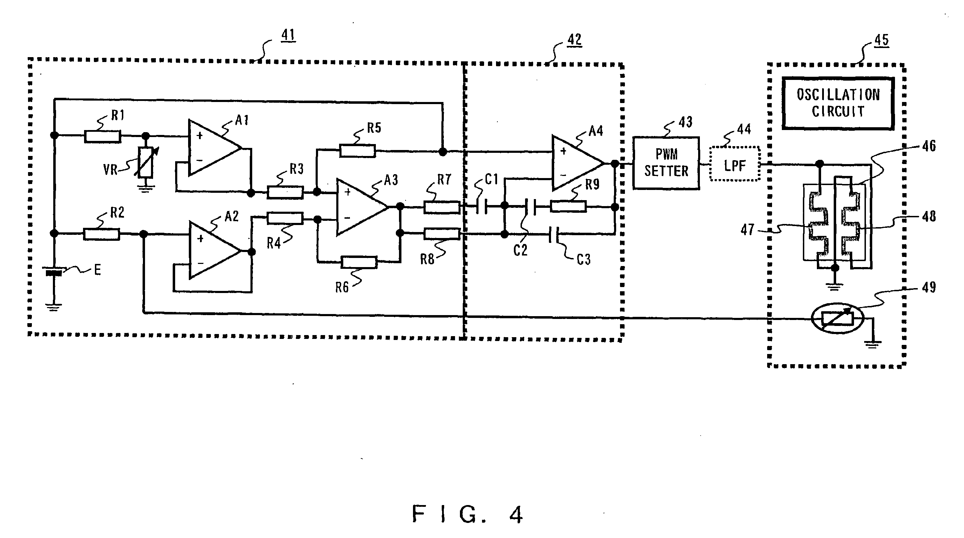

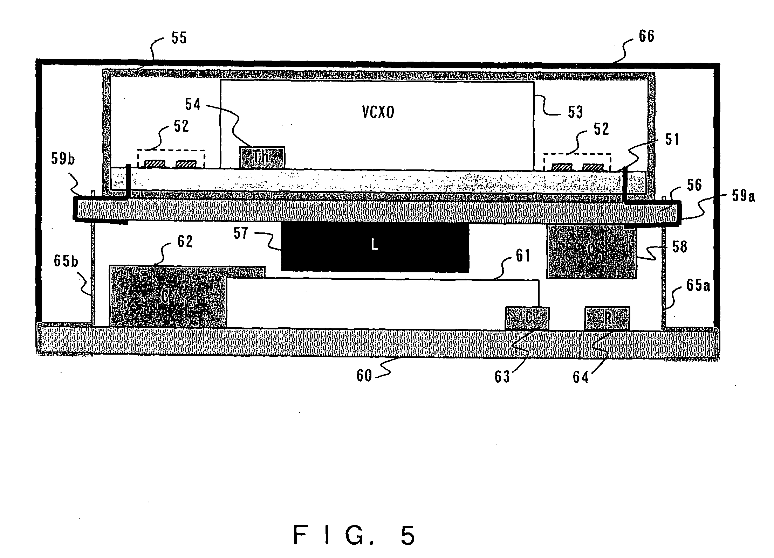

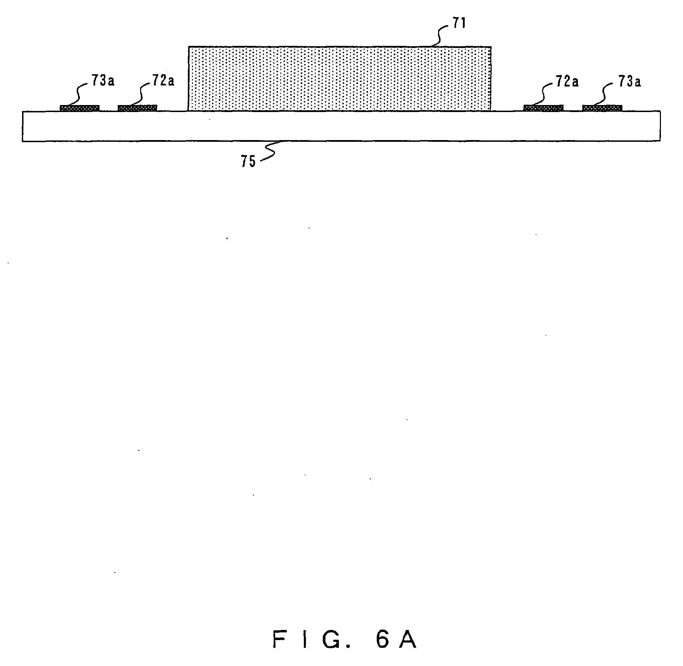

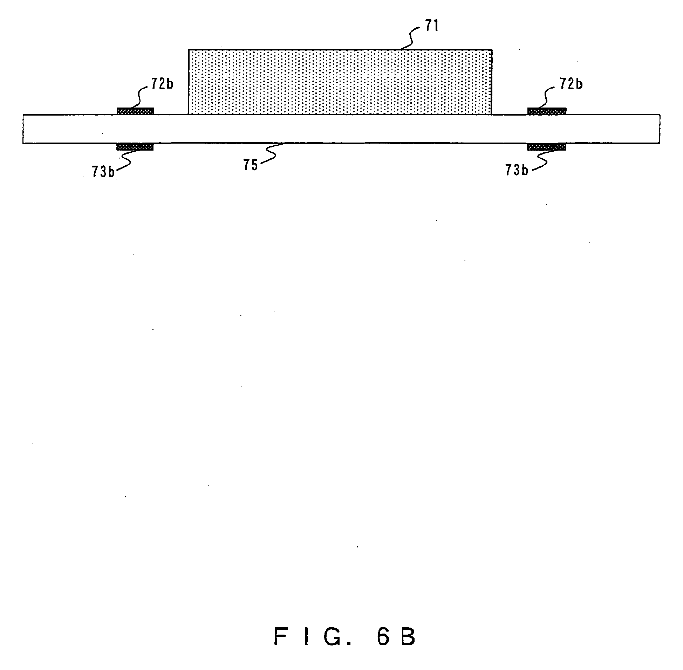

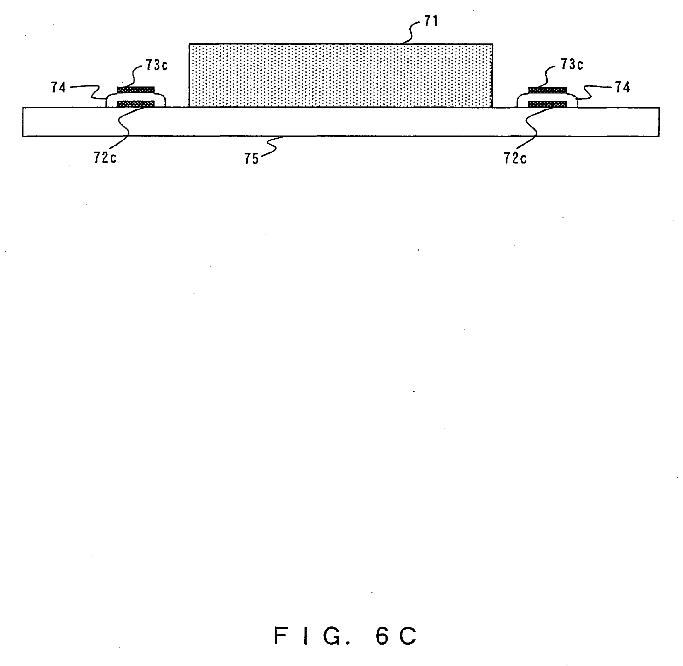

Figs. 6A, 6B and 6C show other configurations of the DDH.

Although so far duplicated heater lines 72a and 73a are arrayed and formed on a substrate 75, as shown in Fig. 6A, the structure of the DDH in the preferred embodiment is not limited to this. For example, the components of the DDH can also be three-dimensionally formed against the substrate 75.

Figs. 6B and 6C show such structures of the DDH.

In Fig. 6B, one heater line 72b constituting the DDH is formed on the same surface as an object whose temperature is kept constant 71 of the substrate 75, and the other heater line 73b is formed on the opposite surface of the substrate 75 as that on which the heater line 72b is formed.

In Fig. 6C, one heater line 72c is formed on the same surface of the substrate 75 as the object whose temperature is kept constant, as in Fig. 6A. However, as for the other heater line 73c, an insulation layer 74 is formed on the heater line 72c, and the other heater line 73c is formed on the insulation layer.

Even if the DDH is formed in any of the forms shown in Figs. 6A, 6B and 6C, in the oscillator of the preferred embodiment, an object whose temperature is kept constant can be enveloped in and heated to keep its temperature constant by a heater. Even when noise is superimposed on the heater lines, since respective electro-magnetic fields of a pair of heater lines mutually cancel, circuit components disposed at the center of the DDH are not affected by the noise.

Although in the above-described preferred embodiments, in the DDH, an object whose temperature is kept constant is enveloped doubly in two heater lines, it can also be enveloped in three or more heater lines triply as long as respective noise can be mutually killed by the electro-magnetic fields of a plurality of heater lines.

## Claims

1. A crystal oscillator, comprising:
a heater (11b, 22) whose heater line is multiplied; and
a control unit for controlling the heater (11b, 22 ) .

2. The crystal oscillator according to claim 1, wherein
said heater (11b, 22) has the duplicate heater lines (13, 14), and
said control unit flows two driving currents each with an opposite phase through the pair of two heater lines (13, 14).

3. The crystal oscillator according to claim 1, wherein
said heater (11b, 22) is disposed in such a way as to envelop an object (23, 24, 25), whose temperature is kept constant by the heater (11b, 22) by the heater lines.

4. The crystal oscillator according to claim 2, wherein
said heater (11b, 22) is disposed in such a way as to envelop an object (23, 24, 25), whose temperature is kept constant by the heater (11b, 22) by the heater lines (13, 14).

5. The crystal oscillator according to claim 1, wherein
said control unit controls said heater (11b, 22) by controlling pulse width modulation.

6. A crystal oscillator, comprising:
a heater (11b, 22) whose heater line is multiplied; and
control means for controlling the heater.

7. A method for heating an object (23, 24, 25) whose temperature is kept constant to keep its temperature constant in a crystal oscillator, comprising:
disposing the object (23, 24, 25) whose temperature is kept constant to be enveloped in duplicated heater lines (13, 14); and
heating the object (23, 24, 25) whose temperature is kept constant to keep its temperature constant by flowing driving currents each with an opposite phase through a pair of duplicated heater lines(13, 14).
